# EUROPEAN PATENT APPLICATION

(11) **EP 2 636 938 A1**
(43) Date of publication of application: **11.09.2013**
(21) Application number: 11819039.6
(22) Date of filing: 20.09.2011
(51) Int. Cl.: F21S 2/00, F21S 8/04, F21Y 101/02

(54) **LIGHT EMITTING DEVICE, BULB-TYPE LAMP, AND ILLUMINATING DEVICE**

(30) Priority: 04.11.2010 JP 2010247953
(71) Applicant: Panasonic Corporation, Osaka 571-8501 (JP)
(72) Inventor: TAKEUCHI, Nobuyoshi, Osaka 540-6207 (JP); MATSUDA, Tsugihiro, Osaka 540-6207 (JP); NAGAI, Hideo, Osaka 540-6207 (JP); MIKI, Masahiro, Osaka 540-6207 (JP); UEMOTO, Takaari, Osaka 540-6207 (JP)
(74) Representative: Appelt, Christian W.
(86) International application number: PCT/JP2011/005279
(87) International publication number: WO 2012/060049

(57) **Abstract**

A light-emitting device capable of effectively dissipating heat generated at an LED is provided. The light-emitting device according to the present invention includes: a base board (140); and an LED chip (150) mounted on the base board (140). The base board (140) is a translucent base board made of a polycrystalline ceramic. A main region of the base board (140) is a region including an element mounted region (A2) on which the LED chip (150) is mounted, and an average grain size of the polycrystalline ceramic in the main region is between 10 µm and 40 µm inclusive. An end portion region (A1) of said base board (140) is a region around an end portion, and an average grain size of the polycrystalline ceramic in the end portion region (A1) is preferably smaller than an average grain size of the polycrystalline ceramic in the element mounted region (A2).

## Description

### [Technical Field]

The present invention relates to a light bulb shaped lamp having a semiconductor light-emitting element and a lighting apparatus which includes the light bulb shaped lamp.

### [Background Art]

Compared to conventional illumination light source, light emitting diodes (LED) which are semiconductor light-emitting elements are small, have high efficiency and long product life. Recent market needs for saving energy and resource boosts the demand for light bulb shaped lamps using LENDS (hereafter simply referred to as "LED light bulb") and lighting apparatuses including the LED light bulbs.

Known properties of LEDs include reduced light output as temperature increases, leading to shorter product life. In response to this problem, a metal case is provided between semispherical globe and a base in a conventional LED light bulb so as to suppress the increase in the temperature of LED (for example, see Patent Literature 1). The metal case functions as a heat sink for radiating heat generated in LED to outside, making it possible to suppress the increase in the temperature of LED.

### [Citation List]

[Patent Literature 1] Japanese Unexamined Patent Application Publication No. 2006-313717

### [Summary of Invention]

However, in the conventional LED light bulb, the LED module is provided on the surface of the metal case in the globe, and thus the light emitted from the LED toward the base is blocked by the case. As described above, the light emitted from the conventional LED light bulb spreads differently from the light emitted from incandescent light bulbs which is omnidirectionally distributed, and thus it is difficult for the conventional LED light bulb to achieve the light-distribution property same as that of incandescent light bulbs.

One possible solution is to change the configuration of the LED light bulbs to the same configuration as the incandescent light bulbs. More specifically, in one possible configuration of such an LED light bulb, a filament coil installed between two lead wires of the incandescent light bulb is replaced with a light-emitting module (LED module) having an LED and a board on which the LED is mounted. In this configuration, the LED module is held in the globe. Accordingly, the light emitted from the LED is not blocked by the case, achieving the light-distribution property of the LED light bulb equivalent to that of the incandescent light bulb.

However, in this configuration, the case which functions as a heat sink is not used, thereby causing a problem that the heat generated at the LED is not effectively dissipated.

The present invention has been conceived in order to solve the problem, and it is an object of the present invention to provide a light-emitting device capable of effectively dissipating the heat generated at the LED while maintaining the omnidirectional distribution of light, a light bulb shaped lamp, and a lighting apparatus.

### [Solution to Problem]

In order to achieve the above object, an aspect of the light-emitting device according to the present invention includes a base board; and a semiconductor light-emitting element mounted on the base board, in which the base board is a translucent base board made of a polycrystalline ceramic, and an average grain size of the polycrystalline ceramic in a main region of the base board is between 10 µm and 40 µm inclusive, the main region being a region including an element mounted region on which the semiconductor light-emitting element is mounted.

With this configuration, the average grain size of the polycrystalline ceramic in the main region of the base board is 10 µm or greater. Therefore, the ceramic is densified. This achieves high heat conductivity of the base board, improving the heat radiation property of the base board in the main region. Furthermore, since the ceramic base board is densified, the main region is highly translucent. Therefore, the light emitted from the semiconductor light-emitting element (light-emitting region) transmits to the back face of the base board, achieving the omnidirectional light-distribution property.

In addition, according to the configuration of the present invention, the average grain size of the polycrystalline ceramic in the main region of the base board is 40 µm or smaller, and thus it is possible to increase the mechanical strength of the base board in the main region.

Furthermore, in an aspect of the light-emitting device according to the present invention, it is preferable that an average grain size of the polycrystalline ceramic in an end portion region of the base board is smaller than the average grain size of the polycrystalline ceramic in the main region, the end portion region being a region around an end portion of the base board.

With this configuration, the average grain size of the polycrystalline ceramic in the end portion region of the base board is smaller than the average grain size in the main region of the base board. Thus, it is possible to increase heat radiation property of the base board in the end portion region. With this, the heat generated at the semiconductor light-emitting element can be effectively conducted from the element mounted region to the end portion region, and can be effectively dissipated to outside of the base board in the end portion region.

Furthermore, since the average grain size of the polycrystalline ceramic in the end portion region of the base board is smaller than the average grain size in the main region of the base board, it is possible to further increase the mechanical strength of the base board in the end portion region. This prevents the base board from broken, or partially chipped or cracked due to the stress applied to the end portion of the base board during fabrication process, for example.

Furthermore, in an aspect of the light-emitting device according to the present invention, it is preferable that the polycrystalline ceramic is polycrystalline alumina.

Furthermore, in an aspect of the light-emitting device according to the present invention, it is preferable that the average grain size of the polycrystalline ceramic in the end portion region is 5 µm or smaller.

Furthermore, in an aspect of a light bulb shaped lamp according to the present invention the light-emitting device; a globe completely surrounding the light-emitting device; a base attached to the globe; and a lead wire for supplying power supplied through the base to the light-emitting device are included.

Furthermore, in an aspect of the light bulb shaped lamp according to the present invention, the light-emitting device is preferably supported such that the light-emitting device is suspended in the globe.

Furthermore, in an aspect of the light bulb shaped lamp according to the present invention, it is preferable that the globe is made of glass transparent to visible light.

Furthermore, an aspect of the lighting apparatus according to the present invention includes the light bulb shaped lamp.

### [Advantageous Effects of Invention]

According to the light-emitting device of the present invention, it is possible to effectively conduct the heat generated at the semiconductor light-emitting element and the heat can be effectively dissipated. Therefore, it is possible to suppress the degradation of the semiconductor light-emitting element.

### [Brief Description of Drawings]

[FIG. 1] FIG. 1 is a diagrammatic perspective view of a light bulb shaped lamp according to the embodiment of the present invention.
[FIG. 2] FIG. 2 is an exploded perspective view of a light bulb shaped lamp according to the embodiment of the present invention.
[FIG. 3] FIG. 3 is a front view of a light bulb shaped lamp according to the embodiment of the present invention.
[FIG. 4A] FIG. 4A is a front view of an LED module according to the embodiment of the present invention.
[FIG. 4B] FIG. 4B is a cross-sectional view of an LED module along X-X' in FIG. 4A according to the embodiment of the present invention.
[FIG. 5] FIG. 5 is an enlarged cross-sectional view of the LED module according to the embodiment of the present invention.
[FIG. 6] FIG. 6 is a circuit diagram of lighting circuit according to the embodiment of the present invention.
[FIG. 7] FIG. 7 is a diagram for illustrating a relationship between an average grain size of polycrystalline alumina in a board and the total transmittance of the board in the LED module according to the embodiment of the present invention.
[FIG. 8] FIG. 8 is a diagram for illustrating a relationship between an average grain size of polycrystalline alumina in a board and the heat conductivity of the board in the LED module according to the embodiment of the present invention.
[FIG. 9] FIG. 9 is a diagram for illustrating a relationship between an average grain size of polycrystalline alumina in a board and the flexural strength of the board in the LED module according to the embodiment of the present invention.
[FIG. 10] FIG. 10 is an enlarged cross-sectional view of the lighting apparatus according to the embodiment of the present invention.

### [Description of Embodiments]

The following shall describe the LED module, the light bulb shaped lamp, and the lighting apparatus according to the embodiment of the present invention with reference to the drawings. However, the present invention is defined by Claims. Accordingly, among the components in the embodiment, the components not described in Claims are not necessary for solving the problem of the present invention but included for a preferable embodiment. Note that, the diagrams are schematic diagrams, and illustration is not necessarily strictly accurate. In the drawings, the same reference numerals are assigned to the same components, and the description for these components shall be omitted or simplified.

### (Overall structure of light bulb shaped lamp)

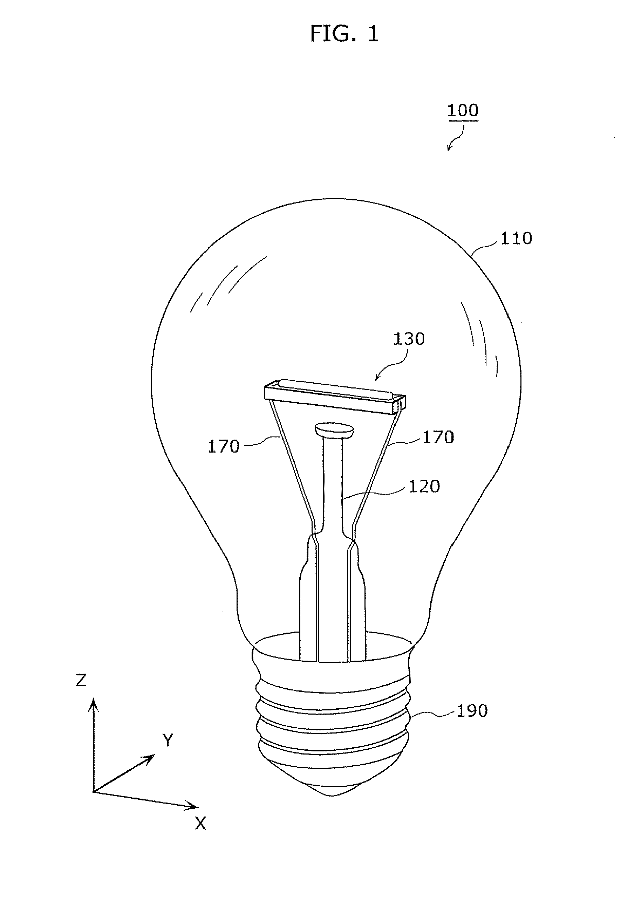

The overall structure of the light bulb shaped lamp 100 according to the embodiment of the present invention shall be described with reference to FIGS. 1 to 3.

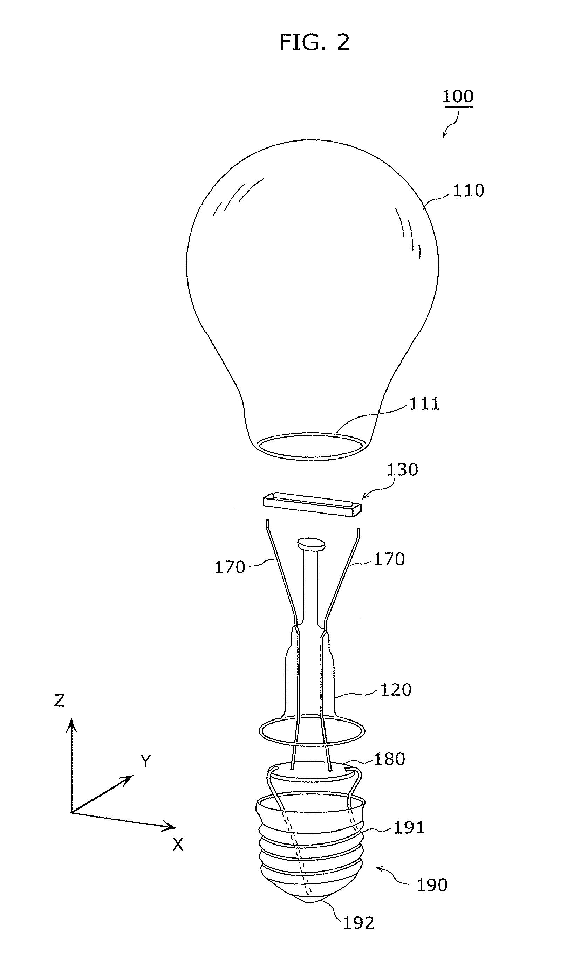

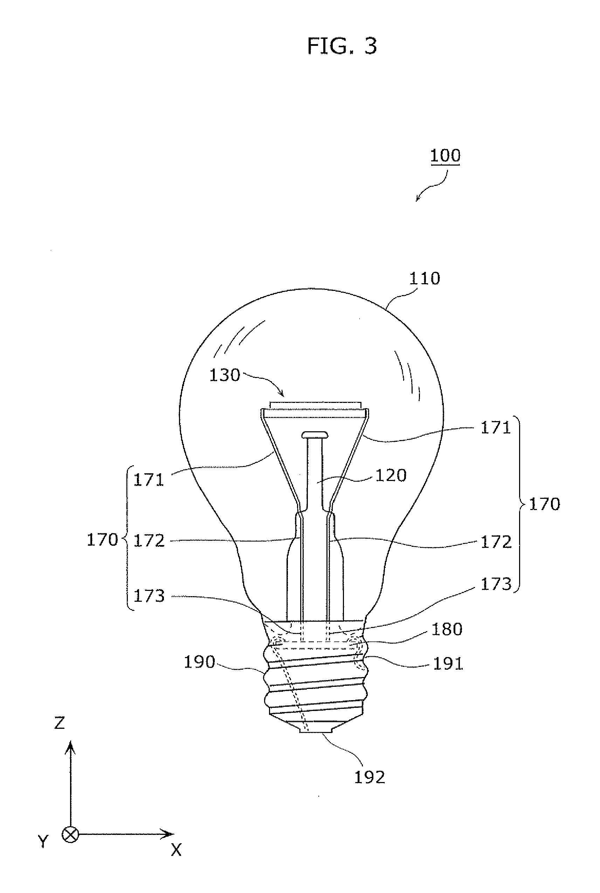

FIG. 1 is a diagrammatic perspective view of a light bulb shaped lamp according to the embodiment of the present invention. FIG. 2 is an exploded perspective view of a light bulb shaped lamp according to the embodiment of the present invention. FIG. 3 is a front view of a light bulb shaped lamp according to the embodiment of the present invention. Note that, in FIG. 3, part of the lighting circuit 180 and a lead wire 170 inside a base 190 is shown in dotted lines.

As illustrated in FIGS. 1 to 3, the light bulb shaped lamp 100 according to the embodiment of the present invention is a light bulb shaped LED lamp replacing an incandescent electric bulb, and includes an LED module (lighting device) 130 having an LED, a translucent globe 110 for housing LED module 130, and a base 190 attached to an opening 111 of the globe 110. In addition, the light bulb shaped lamp 100 includes a stem 120, two lead wires 170, and a lighting circuit 180.

The following shall describe components of the light bulb shaped lamp 100 according to the embodiment of the present invention.

### (Globe)

The globe 110 is a hollow component made of silica glass transparent to visible light. Accordingly, the LED module 130 housed in the globe 110 is visible from outside of the globe 110. This structure suppresses loss of light from the LED module 130 by the globe 110. In addition, since the globe 110 is not made of resin but glass, the globe 110 is highly resistant to heat.

The globe 110 has a shape with one end closed in a spherical shape, and the other end has an opening 111. In other words, the shape of the globe 110 is that a part of hollow sphere is narrowed down while extending away from the center of the sphere. In this embodiment, the shape of the globe 110 is Type A (JIS C7710) which is the same as a common incandescent light bulb. The globe 110 also has an opening 111 away from the center of the sphere.

Note that, the shape of the globe 110 does not have to be Type A. For example, the shape of the globe 110 may be Type G, Type E, or others. The globe 110 does not have to be transparent to visible light either, or made of silica glass. For example, the globe 110 may be a component made of resin such as acrylic.

### (Stem)

The stem 120 is provided extending from the opening 111 of the globe 110 toward the inside of the globe 110. More specifically, a rod-shaped extending portion extending to the vicinity of the LED module 130 in the Z-axis direction is provided in one end of the stem 120. In other words, the stem 120 according to the embodiment is a component that would be obtained by extending the stem used for a common incandescent light bulb extending toward the inside of the globe 110. Note that, the stem 120 may be a stem used for a common incandescent light bulb.

The end portion of the stem 120 on the base side is formed in a flared shape coinciding with the shape of the opening 111. The end portion of the stem 120 formed in the flared shape is joined with the opening 111 of the globe 110 so as to close the opening of the globe 110. In addition, parts of two lead wires 170 are partially sealed in the stem 120. Accordingly, it is possible to supply power to the LED module 130 in the globe 110 from outside of the globe 110 keeping the globe 110 airtight. Accordingly, the light bulb shaped lamp 100 can prevent water or water vapor from entering the globe 110 for a long period of time, and it is possible to suppress the degradation of the LED module 130 and a part connecting the LED module 130 and the lead wire 170 due to moisture.

The stem 120 is made of soft glass transparent to visible light. With this, the light bulb shaped lamp 100 can suppress the loss of light generated at the LED module 130, by the stem 120. In addition, the light bulb shaped lamp 100 can prevent the shadow formed by the stem 120. Furthermore, white light generated by the LED module 130 lights up the stem 120. Thus, the light bulb shaped lamp 100 can achieve visually superior appearance.

Note that, the stem 120 does not necessarily close the opening at the globe 110, and may be attached to a part of the opening 111.

### (LED module)

The LED module 130 is a light-emitting module, and is housed in the globe 110. It is preferable that the LED module 130 is positioned at the center of the spherical shape formed by the globe 110 (for example, inside a large diameter part at which the inner diameter of the globe 110 is large). With the LED module 130 positioned at the center, the light bulb shaped lamp 100 can achieve omnidirectional light distribution property when the light bulb shaped lamp 100 is switched on. The omnidirectional light distribution property is approximated to a common incandescent light bulb using conventional filament coil.

In addition, the LED module 130 is supported by two lead wires 170, and is suspended in the globe 110 (in the large-diameter part of the globe 110 in the embodiment). In other words, the LED module 130 is supported by the two lead wires 170 in the globe 110, away from the inner surface of the globe 110. The LED module 130 is electrically connected to the two lead wires 170, and the LED module 130 emits light by the power supplied from the two lead wires 170. Power supply terminals are provided at the both ends of the LED module 130, and the power supply terminal and the lead wires are electrically connected by solder or others.

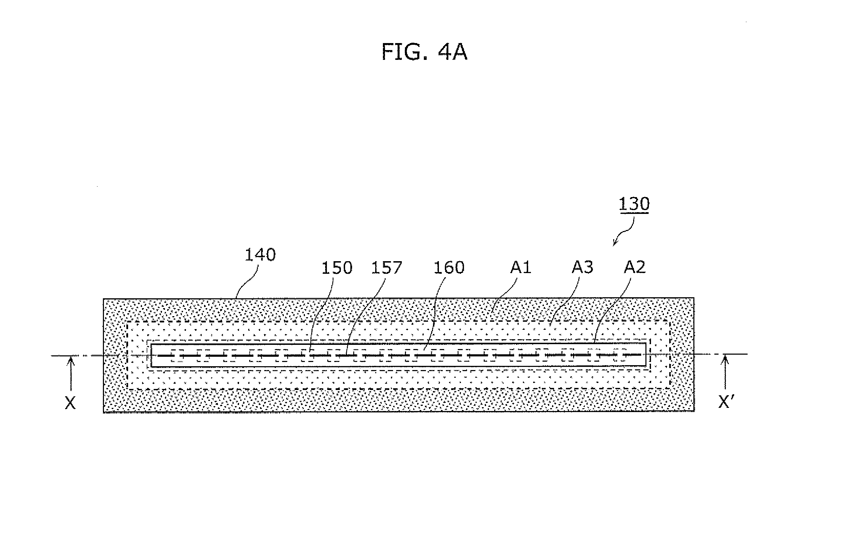

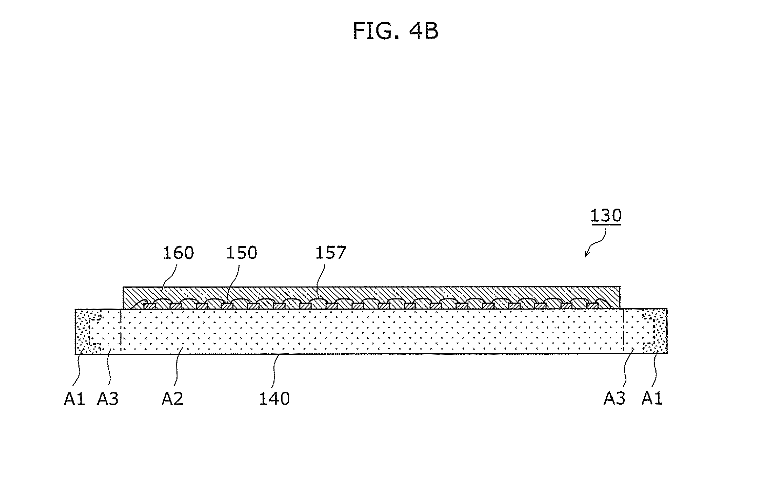

Next, the components of the LED module 130 according to the embodiment shall be described in detail with reference to FIGS. 4A and 4B. FIG. 4A is a plan view of the LED module according to the embodiment of the present invention. FIG. 4B is a cross-sectional view of the LED module according to the embodiment along X-X in FIG. 4A.

As illustrated in FIG. 4A and FIG. 4B, the LED module 130 according to the embodiment is a light-emitting device according to the present invention, and includes a base board 140, LED chips 150, and a sealing material 160. Note that, the LED module 130 is provided with the surface on which the LED chips 150 toward the top of the globe 110 (in a positive direction of Z direction). The following shall describe components of the LED module 130 in detail.

First, the base board 140 shall be described. The base board 140 is composed of a material translucent to the light emitted from the sealing material 160. In this embodiment, white light is emitted from the sealing material 160. Accordingly, the base board 140 is formed by a material translucent to visible light. A translucent ceramic board composed of polycrystalline ceramic may be used as the base board 140. In this embodiment, a long alumina board made of alumina (aluminium oxide: Al₂O₃) is used.

In this embodiment, the base board 140 is a rectangle board, and has a surface on which the LED chips 150 are mounted as a mounted surface, and the other side of the mounted surface is referred to as a back surface. As illustrated in FIG. 4A, a region around the end portion of the base board 140 is referred to as an end portion region A1, and a region of the base board 140 on which the LED chips 150 are mounded is referred to as element mounted region A2. A region between the end portion region A1 and the element mounted region A2 shall be referred to as an intermediate region A3.

As illustrated in FIG. 4A and FIG. 4B, the end portion A1 in the base board 140 is a region surrounding the end portion along the whole circumference of the base board 140, and is a region having a constant width from the edge of the side surface in a side surface of the base board 140 and the mounting surface and back surface of the base board 140. The predetermined width in the end portion region A1 is preferably 0.2 to 1.0 mm from the end of the base board 140. Note that, in this embodiment, a long board with large aspect ratio in which the length in the longer direction (X direction) is 25 mm and the length in the shorter direction (Y direction) is 6 mm is used. However, a board with small aspect ratio, for example, a rectangle board may be used.

The main region of the base board 140 is a region other than the end portion region A1 in the base board 140, and includes the element mounted region A2 and the intermediate region A3. The element mounted region A2 includes a region on which the LED chips 150 are mounted and on which the sealing material 160 is formed, and is a light-emitting region in which white light is emitted by the LED chips 150 and the sealing material 160. More specifically, the element mounted region A2 is a region immediately below the base 140 near the sealing material 160. The intermediate region A3 is a region between the end portion region A1 and the element mounted region A2. It is preferable that the intermediate region A3 basically has the same configuration as the element mounted region A2.

In this embodiment, an average grain size of the polycrystalline ceramic in the main region in the base board 140 is 10 µm or larger and 40 µm or smaller. In addition, in the base board 140, the average grain size of the polycrystalline ceramic in the end portion region A1 is smaller than the average grain size of the polycrystalline ceramic in the element mounted region A2. In this embodiment, polycrystalline alumina is used as the polycrystalline ceramic, and the average grain size of the polycrystalline alumina in the end portion region A1 is 5 µm or smaller.

The base board 140 having different average grain sizes is formed as described below.

Generally, a ceramic board is fabricated by adding organic binder to a mixture of ceramic material such as alumina particles with small grain size, a scatterer such as zirconia (ZrO₂), and a sintering agent (additive), pressure-forming and burning the mixed material. Magnesia (magnesium oxide: MgO) is used as the sintering agent, for example, which affects grain growth of polycrystalline ceramic at the time of burning. More specifically, the grain growth of polycrystalline ceramic is suppressed when the amount of magnesia is increased, and the average grain size of the polycrystalline ceramic remains small. In contrast, when the amount of magnesia is reduced, the grain growth of the polycrystalline ceramic is promoted, increasing the average grain size of the polycrystalline ceramic.

In this embodiment, before sintering, magnesia is partially dipped on the end portion region A1 of the base board 140, a region in which smaller average grain size is preferred. With this, the amount of magnesia in the end portion A1 can be greater than the amount of magnesia in the regions other than the end portion region A1 (the element mounted region A2 and the intermediate region A3). Consequently, the grain growth of the polycrystalline ceramic in the end portion region A1 at the time of burning is suppressed. Accordingly, after burning, the average grain size of the polycrystalline ceramic in the end portion region A1 can remain small, making the average grain size of the polycrystalline ceramic in the end portion region A1 smaller than the average grain size of the polycrystalline ceramic in the regions other than the end portion region A1.

Note that, although not illustrated, a metal line pattern is formed on the mounting surface of the base board 140, and each LED chip 150 is electrically connected to the metal line pattern through wire or others.

Next, the LED chip 150 shall be described. The LED chip 150 is an example of the semiconductor light-emitting element, and is a bare chip which emits visible light in one color. In this embodiment, a blue LED chip which emits blue light when energized. The LED chip 150 is mounted in a straight line on the mounting surface of the base board 140 along the longer direction of the base board 140 at the central part of the base 140 in the shorter direction. More specifically, twelve LED chips 150 are mounted in a straight line.

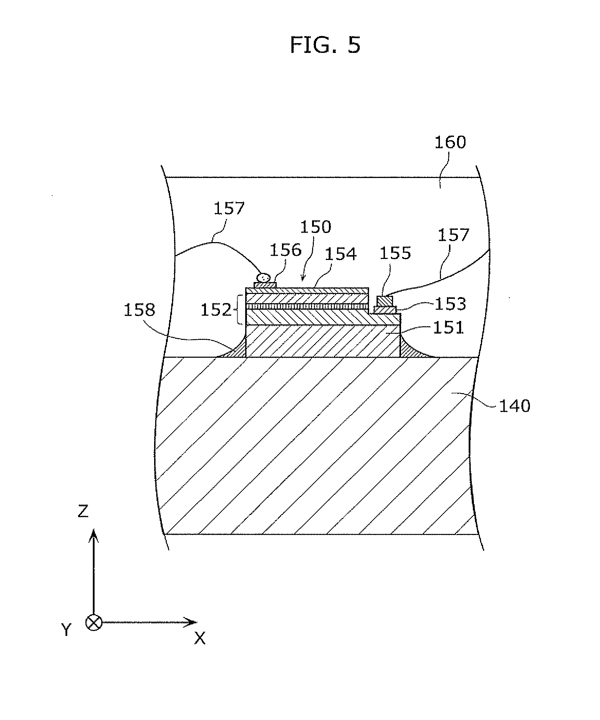

As illustrated in FIG. 5, the LED chip 150 according to the embodiment is vertically long (600 µm long, 300 µm wide, and 100 µm thick). The LED chip 150 includes a sapphire board 151 and nitride semiconductor layers 152 each having different composition, which are stacked above the sapphire board 151.

A cathode electrode 153 and an anode electrode 154 are formed at an end portion of the upper surface of the nitride semiconductor layer 152. Wire bonding portions 155 and 156 are formed on the cathode electrode 153 and the anode electrode 154, respectively.

The cathode electrode 153 and the anode electrode 154 in the LED chips 150 next to each other are electrically connected in series by a gold wire 157 through the wire bonding portions 155 and 156. The cathode electrode 153 or the anode electrode 154 in the LED chips 150 at the ends is connected to a power supply terminal 141 by the gold wire 157.

Each of the LED chips 150 is mounted on the base board 140 by translucent chip bonding material 158 such that a surface of the LED chip 150 on the sapphire board 151 side faces the mounting surface of the base board 140.

Silicon resin including filler made of metal oxide may be used as the chip bonding material, for example. Using the translucent material for the chip bonding material can reduce the loss of light emitted from the surface of the LED chip 150 on the side of the sapphire board 151 and the side surfaces of the LED chip 150, preventing the shadow of the chip bonding material.

Note that, an example in which the LED chips 150 are mounted on the base board 140 is illustrated in this embodiment. However, the number of the LED chips 150 may be changed as necessary depending on the use of the light bulb shaped lamp 100. For example, as a replacement for a miniature light bulb, one LED chip 150 may be mounted on the base board 140.

In this embodiment, LED chips 150 are mounted on the base board 140 in a line. However, the LED chips 150 may be mounted in multiple lines, for example, three lines.

Next, the sealing material 160 shall be described. The sealing material 160 is formed in a straight line (stripe) covering the LED chips 150. The sealing material 160 includes a phosphor which is a material for converting wavelength of light, and also serves as a wavelength conversion layer which converts the wavelength of light emitted from the LED chip 150. A phosphor-containing resin in which predetermined phosphor particles (not illustrated) and light diffusion material (not illustrated) are dispersed may be used as the sealing material 160.

As phosphor particles, when the LED chip 150 is a blue LED chip which emits blue light, YAG yellow phosphor particles such as (Y, Gd)₃Al₅O₁₂:Ce³⁺, Y₃Al₅O₁₂:Ce³⁺ in order to obtain white light. With this, part of the blue light emitted from the LED chip 150 is converted to yellow light by wavelength conversion of the yellow phosphor particles included in the sealing material 160. The blue light which is not absorbed by the yellow phosphor particles and the yellow light which is converted by the yellow phosphor particles by wavelength conversion are diffused and mixed in the sealing material 160. After that, the mixed light is emitted from the sealing material 160 as white light.

Particles such as silica are used as the light diffusion material. In this embodiment, the translucent base board 140 is used. Accordingly, the white light emitted from the striped sealing material 160 transmits inside the base board 140, and is emitted from the side surfaces of the base board 140 on which no LED chip 150 is mounted. Therefore, the base board 140 appears shining like a filament coil of a conventional incandescent light bulb from any side of the base board 140 when the light bulb shaped lamp 100 is switched on.

Note that, the wavelength conversion material included in the sealing material 160 may be a yellow phosphor such as (Sr, Ba)₂SiO₄:Eu²⁺, Sr₃SiO₅:Eu²⁺, for example. Alternatively, the wavelength conversion material may be a green phosphor such as (Ba, Sr)₂SiO₄:Eu²⁺, Ba₃Si₆O₁₂N₂:Eu²⁺. Alternatively, the wavelength conversion material may be a red phosphor such as CaAlSiN₃:Eu²⁺, Sr₂(Si, Al)₅(N, O)₈:Eu²⁺.

The sealing material 160 may not be necessarily be made of silicon resin, and may be made of an organic material such as fluorine series resin or an inorganic material such as a low-melting-point glass or a sol-gel glass. Since the inorganic materials are more highly resistant than the organic material, the sealing material 160 made of inorganic material is advantageous to increasing luminance.

Alternatively, the sealing material 160 may be provided on a surface on which no LED chip 150 is mounted. With this, part of the blue light which transmits inside the base board 140 and is emitted from the side surfaces on which no LED chip 150 is mounted is converted to yellow light. Accordingly, it is possible to change the color of light emitted from the side surfaces on which no LED chip 150 is mounted closer to the color of light is directly emitted from the sealing material 160.

The sealing material 160 with the configuration described above is formed by the following two processes, for example. First, in the first process, the sealing material 160 which is an uncured paste including the wavelength conversion material is applied in a continuous straight line on the LED chips 150 by a dispenser. Next, in the second process, the applied paste of sealing material 160 is cured. The cross-section in X direction of the sealing material 160 formed as described above is dome-shaped, and is 1 mm wide and 0.2 mm high.

### (Lead wire)

Two lead wires 170 are electric wires for holding and supplying power. More specifically, the lead wires 170 holds the LED module 130 at a constant position in the globe 110, and supplies power supplied from the base 190 to the LED chips 150. Each of the lead wire 170 is a composite wire including an internal lead wire 171, a Dumet wire (copper-clad nickel steel wire) 172 and an external lead wire 173 joined in this order.

The internal lead wire 171 is the electric wire extending from the stem 120 to the LED module 130, is joined with the base board 140, and supports the LED module 130. The Dumet wire 172 is sealed in the stem 120. The external lead wire 173 is a wire extending from the lighting circuit 180 to the stem 120.

Here, it is preferable that the lead wire 170 is a metal wire including copper having high thermal conductivity. With this, the heat generated at the LED module 130 can be actively transferred to the base 190 through the lead wire 170.

Note that, the lead wire 170 does not necessarily have to be a composite wire, and may be a single wire made of the same metal wire. In addition, two lead wires 170 do not have to be provided. For example, when the light bulb shaped lamp 100 includes a plurality of the LED modules 130 in the globe 110, two lead wires 170 may be provided for each of the LED modules 130.

The lead wire 170 is preferably attached to the base board 140 biasing the base 140 toward the stem 120. With this, the base board 140 can be fixed and held to the stem 120 more firmly.

### (Lighting circuit)

The lighting circuit 180 is a circuit for causing the LED chips 150 to emit light, and is housed in the base 190. More specifically, the lighting circuit 180 includes a plurality of circuit elements, and a circuit board on which each of the circuit elements is mounted. In this embodiment, the lighting circuit 180 converts the AC power received from the base 190 to the DC power, and supplies the DC power to the LED chips 150 through the two lead wires 170.

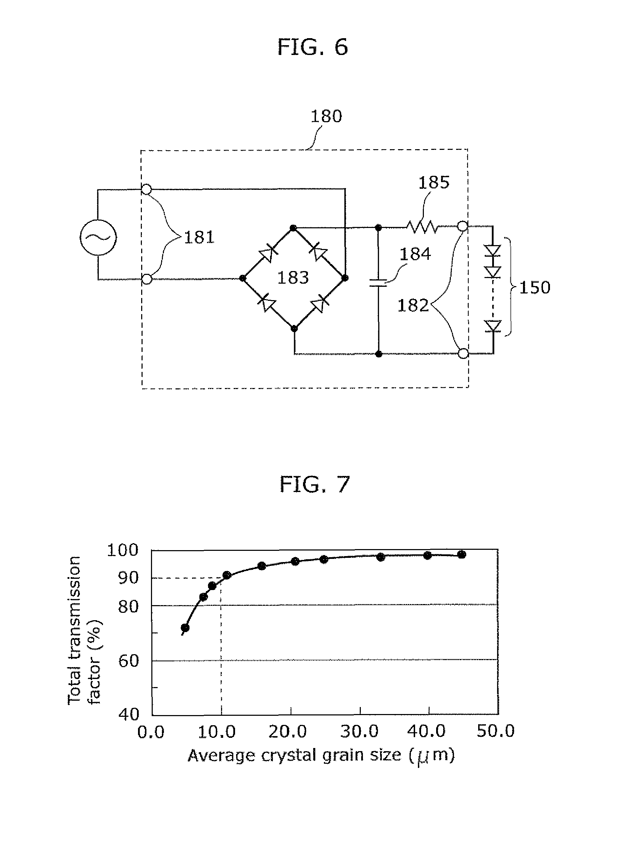

FIG. 6 is a circuit diagram of the lighting circuit according to the embodiment of the present invention. As illustrated in FIG. 6, the lighting circuit 180 includes a diode bridge 183 for rectification, a capacitor 184 for smoothing, and a resistor 185 for adjusting current. Input terminals of the diode bridge 183 are connected to input terminals 181 of the lighting circuit 180. One of the output terminals of the diode bridge 183 and one end of the resistor 183 are connected to the output terminals 182 of the lighting circuit 180. An end of the capacitor 184 and the other end of the resistor 185 are connected to the other of the output terminals of the diode bridge 183.

The input terminal 181 is electrically connected to the base 190. More specifically, one of the input terminals 181 is connected to the screw 191 on the side surface of the base 190. The other of the input terminals 181 is connected to the eyelet 192 at the bottom of the base 190.

The output terminals 182 are connected to the lead wires 170, and are electrically connected to the LED chips 150.

Note that, the light bulb shaped lamp 100 does not have to include the lighting circuit 180. For example, the lighting circuit 180 is not necessary for the light bulb shaped lamp 100 when the DC power is directly supplied from the lighting equipment, a battery cell, or others. In this case, one of the external lead wires 173 is connected to the screw 191, and the other of the external lead wire 173 is connected to the eyelet 192.

Note that, the lighting circuit 180 is not limited to a smoothing circuit, but may be an appropriate combination of light-adjusting circuit, voltage booster, and others.

### (Base)

The base 190 is provided at the opening 111 of the globe 110. More specifically, the base 190 is attached to the globe 110 using an adhesive such as cement to cover the opening 111 of the globe 110. In this embodiment, the base 190 is an E26 base. The light bulb shaped lamp 100 is attached to a socket for E26 base connected to the commercial AC power source for use.

Note that, the base 190 does not have to be an E26 base, and maybe a base of other size, such as E17. In addition, the base 190 does not have to be a screw base, and may be a base in a different shape such as a plug-in base.

As described above, according to the LED module 130 according to the embodiment, the average grain size of the polycrystalline ceramic in the main region of the base board 140 is 10 µm or larger. With this, it is possible to densify the ceramic base board, increasing the thermal conductivity of the base board 140. With this, it is possible to effectively conduct heat generated at the LED chips 150 and dissipate the heat. Furthermore, since the ceramic base board is densified, the main region is highly translucent. Thus, the light from the LED chips 1.50 (light-emitting part) can transmit the back surface of the base board 140, thereby achieving omnidirectional light distribution property.

Furthermore, in the LED module 130 according to the embodiment, the average grain size of the polycrystalline ceramic in the main region in the base board 140 is set to be 40 µm or smaller. This increases the mechanical strength of the base board 140 in the main region.

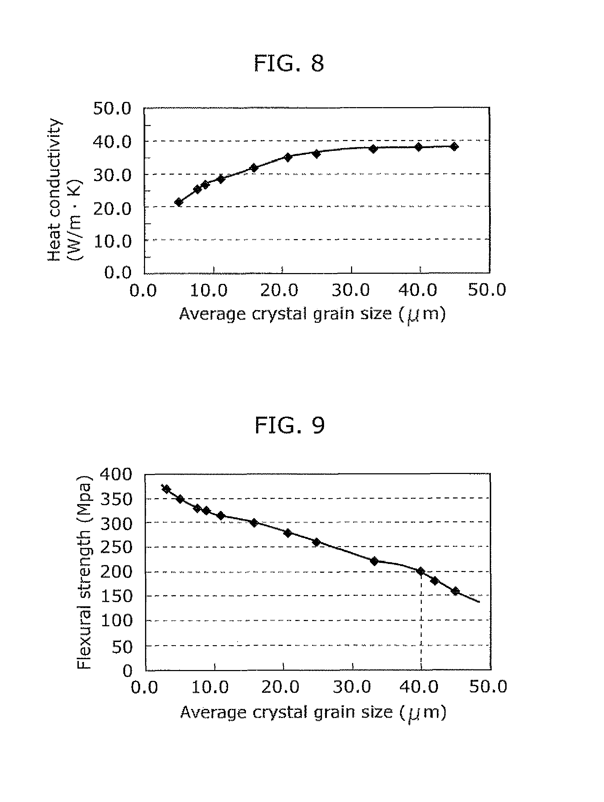

As described above, according to the LED module 130 in the embodiment, it is possible to fabricate a light bulb shaped LED lamp with good thermal property and mechanical property, and which achieves omnidirectional light distribution property equivalent to that of an incandescent lamp using a conventional filament coil. The optical property, thermal property, and mechanical property of the LED module 130 according to the embodiment shall be described with reference to FIGS. 7 to 9. FIG. 7 is a diagram for illustrating the relationship between the average grain size of the polycrystalline alumina and the total transmittance (optical property) in the board of the LED module according to the embodiment of the present invention. FIG. 8 is a diagram for illustrating the relationship between the average grain size of the polycrystalline alumina and the heat conductivity (thermal property) in the board of the LED module according to the embodiment of the present invention. FIG. 9 is a diagram for illustrating the relationship between the average grain size of the polycrystalline alumina and the flexural strength (mechanical property) in the board of the LED module according to the embodiment of the present invention.

As illustrated in FIG. 7, in the LED module 130 according to the embodiment, by having 10 µm or more of the average grain size of the polycrystalline alumina in the main region, it is possible to set the total transmittance in the main region to be 90% or higher, which is suitable for the omnidirectional light distribution property. As illustrated in FIG. 8, by having 10 µm or more of the average grain size of the polycrystalline alumina in the main region, the heat conductivity of the main region can be high at 28W/m•K or higher. As illustrated in FIG. 9, the flexural strength sharply decreases once the average grain size of the polycrystalline alumina in the main region exceeds 40 µm. Accordingly, it is preferable to set the average grain size of the polycrystalline alumina in the main region as 40 µm or smaller.

In the LED module 130 according to the embodiment, in the end portion region A1 in the base board 140, the average grain size of the polycrystalline ceramic is smaller than the average grain size in the main region in the base board 140. With this, it is possible to increase the surface area of the polycrystalline ceramic, thereby increasing the thermal emissivity of the base board 140 in the end portion region A1. As described above, in the LED module 130 according to the embodiment, the end portion region A1 has high emissivity, and the element mounted region A2 has high thermal conductivity. Thus, it is possible to effectively conduct heat generated at the LED chip 150, and to effectively dissipate heat to outside of the base board 140. As a result, the light bulb shaped lamp 100 can further suppress reduction in the light-emission efficacy and reduction in product life of the LED chips 150 due to increased temperature.

Furthermore, according to the LED module 130 according to this embodiment, the average grain size of the polycrystalline ceramic in the end portion region A1 in the base board 140 is smaller than the average grain size in the main region. Accordingly, in the end portion region A1, the mechanical strength of the base board 140 can be further improved. With this, it is possible to prevent the base board 140 from broken or a part of the base board 140 from chipping or cracking due to the stress applied to the end portion of the base board 140 during the fabrication process or others.

Furthermore, the light bulb shaped lamp 100 according to the embodiment of the present invention includes the LED module 130 surrounded by the globe 110 which is entirely translucent. With this, the white light generated at the LED module 130 is omnidirectionally emitted, without blocked by the case. Therefore, it is possible to achieve the omnidirectional light distribution property equivalent to that of conventional incandescent light bulbs.

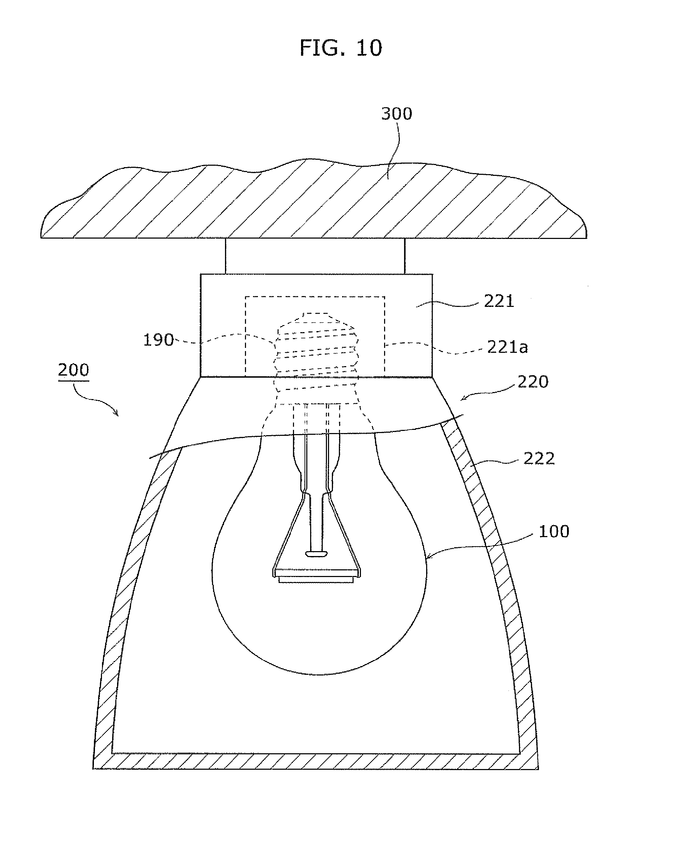

Next, the lighting apparatus 200 according to the embodiment of the present invention shall be described with reference to FIG. 10. FIG. 10 is a schematic cross-sectional view of the lighting apparatus according to the embodiment of the present invention.

As illustrated in FIG. 10, the lighting apparatus 200 according to the present invention is attached to a ceiling 300 in a room when in use, and includes a light bulb shaped lamp 100 and a lighting equipment 220.

The lighting equipment 220 is for turning the light bulb shaped lamp 100 on and off, and includes an equipment body 221 attached to the ceiling 300 and a lamp cover 222 covering the light bulb shaped lamp 100.

The equipment body 221 includes a socket 221a. A base 190 of the light bulb shaped lamp 100 is screwed into the socket 221a. Power is supplied to the light bulb shaped lamp 100 through the socket 221a.

Note that, although the lighting apparatus 200 in FIG. 10 includes one light bulb shaped lamp 100, the lighting apparatus 200 may include more than one light bulb shaped lamp 100.

The lighting device, the light bulb shaped lamp, and the lighting apparatus according to the present invention have been described above based on the embodiment. However, the present invention is not limited to the embodiment.

For example, the average grain size of the polycrystalline ceramic in the main region of the base board 140 is 10 µm or larger and 40 µm or smaller. However, the average grain size of the polycrystalline ceramic in all of the base board 140 including the end portion region A1 may be 10 µm or larger and 40 µm or smaller. As described above, having the average grain size of the polycrystalline ceramic in the entire base board 140 10 µm or larger and 40 µm or smaller densifies the ceramic base board. Therefore, it is possible to increase the thermal conductivity of the entire base board 140. With this, it is possible to effectively conduct heat generated at the LED chips 150 so as to dissipate the heat, and to make the entire base board 140 highly translucent. In addition, having the average grain size of the polycrystalline ceramic in the entire base board as 40 µm or smaller secures stable mechanical strength of the entire base board 140. Furthermore, when applying the light-emitting device (LED module) according to this embodiment to the light bulb shaped lamp, it is preferable that the light-emitting device is suspended in the globe, and particularly at the center part of the globe. Note that, when holding the light-emitting device suspended in the globe, the light-emitting device may be supported by the lead wire such that the light-emitting device is held suspended in the globe. Alternatively, the light-emitting device may be held by the stem floating in the globe, instead of the lead wire.

In this embodiment, an alumina board is used as the base board 140, but it is not limited to this example. As the material for the base board 140, transmissive aluminium nitride or transmissive magnesium oxide may be used. The shape of the base board 140 may not be limited to rectangle.

Alternatively, in the embodiment, the base board 140 and the stem 120 may be connected by heat-conductive resin or others. With this, the heat generated at the LED module 130 can be actively transferred to the base 190 through the stem 120. Note that, in this case, it is preferable that the back surface of the element mounted region A2 in the base board 140 and the stem 120.

In this embodiment, the LED module is configured to emit white light using the LED chips and the sealing material including the wavelength conversion material. However, it is not limited to this example. For example the LED module can be configured with yellow to amber LED chips along with translucent sealing material that does not include the wavelength conversion material. Light bulb with low luminous flux is generally used for purposes that dos not require high color rendition. For these purposes, the light from incandescent light bulb can be reproduced using only the light from the LED chip.

Needless to say, the color of light emitted from the LED chip, whether or not the wavelength conversion material is used, or the type of the wavelength conversion material may also be selected appropriately. For example, a configuration in which LED chips of light's three primary colors, i.e., blue, green, and red are used to obtain white light, a configuration in which LED chips having a wavelength from violet to a near-ultraviolet range, and phosphors of the three primary colors, i.e., blue, green, and red are used to obtain white light, or a configuration in which light in a single color such as blue only, green only, or red only is used are possible.

Those skilled in the art will readily appreciate that many modifications are possible in the exemplary embodiments without materially departing from the novel teachings and advantages of this invention. Accordingly, all such modifications are intended to be included within the scope of this invention.

### [Industrial Applicability]

The present invention is useful for a light-emitting device having a semiconductor light-emitting element such as LED as a light source, an LED light bulb replacing conventional incandescent light bulbs, and a lighting apparatus including the LED light bulb.

### [Reference Signs List]

- 100: Light bulb shaped lamp
- 110: Globe
- 111: Opening
- 120: Stem
- 130: LED module
- 140: Base board
- 150: LED chip
- 151: Sapphire board
- 152: Nitride semiconductor layer
- 153: Cathode electrode
- 154: Anode electrode
- 155, 156: Wire bonding portion
- 157: Gold wire
- 158: Chip bonding material
- 160: Sealing material
- 170: Lead wire
- 171: Internal lead wire
- 172: Dumet wire
- 173: External lead wire
- 180: Lighting circuit
- 181: Input terminal
- 182: Output terminal
- 183: Diode bridge
- 184: Capacitor
- 185: Resistor
- 190: Base
- 191: Screw
- 192: Eyelet
- 200: Lighting apparatus
- 220: Lighting equipment
- 221: Equipment body
- 221a: Socket
- 222: Lamp cover
- 300: Ceiling
- A1: End portion region
- A2: Element mounted region

## Claims

1. A light-emitting device comprising:
a base board; and
a semiconductor light-emitting element mounted on said base board,
wherein said base board is a translucent base board made of a polycrystalline ceramic, and
an average grain size of the polycrystalline ceramic in a main region of said base board is between 10 µm and 40 µm inclusive, the main region being a region including an element mounted region on which said semiconductor light-emitting element is mounted.

2. The light-emitting device according to Claim 1,
wherein an average grain size of the polycrystalline ceramic in an end portion region of said base board is smaller than the average grain size of the polycrystalline ceramic in the main region, the end portion region being a region around an end portion of said base board.

3. The light-emitting device according to Claim 1 or Claim 2,
wherein the polycrystalline ceramic is polycrystalline alumina.

4. The light-emitting device according to Claim 2 or Claim 3,
wherein the average grain size of the polycrystalline ceramic in the end portion region is 5 µm or smaller.

5. A light bulb shaped lamp comprising:
the light-emitting device according to one of Claims 1 to 4;
a globe completely surrounding said light-emitting device;
a base attached to said globe; and
a lead wire for supplying power supplied through said base to said light-emitting device.

6. The light bulb shaped lamp according to Claim 5,
wherein the light-emitting device is supported such that the light-emitting device is suspended in said globe.

7. The light bulb shaped lamp according to Claim 5 or Claim 6,
wherein said globe is made of glass transparent to visible light.

8. A lighting apparatus comprising
the light bulb shaped lamp according to one of Claims 5 to 7.

## Amended claims

### Amended claims under Art. 19.1 PCT

**1.** A light-emitting device comprising:
a base board; and
a semiconductor light-emitting element mounted on said base board,
wherein said base board is a translucent base board made of a polycrystalline ceramic and having a transmission factor of 90% or higher, and
an average grain size of the polycrystalline ceramic in a main region of said base board is between 10 µm and 40 µm inclusive, the main region being a region including an element mounted region on which said semiconductor light-emitting element is mounted.

**2.** A light-emitting device comprising:
a base board; and
a semiconductor light-emitting element mounted on said base board,
wherein said base board is a translucent base board made of polycrystalline ceramic,
an average grain size of the polycrystalline ceramic in a main region of said base board is between 10 µm and 40 µm inclusive, and an average grain size of the polycrystalline ceramic in an end portion region of said base board is smaller than the average grain size of the polycrystalline ceramic in the main region, the main region being a region including an element mounted region on which said semiconductor light-emitting element is mounted, and the end portion region being a region around an end portion of said base board.

**3.** The light-emitting device according to Claim 1 or Claim 2,
wherein the polycrystalline ceramic is polycrystalline alumina.

**4.** The light-emitting device according to Claim 2,
wherein the average grain size of the polycrystalline ceramic in the end portion region is 5 µm or smaller.

**5.** A light bulb shaped lamp comprising:
the light-emitting device according to one of Claims 1 to 4;
a globe completely surrounding said light-emitting device;
a base attached to said globe; and
a lead wire for supplying power supplied through said base to said light-emitting device.

**6.** The light bulb shaped lamp according to Claim 5,
wherein the light-emitting device is supported such that the light-emitting device is suspended in said globe.

**7.** The light bulb shaped lamp according to Claim 5 or Claim 6,
wherein said globe is made of glass transparent to visible light.

**8.** A lighting apparatus comprising
the light bulb shaped lamp according to one of Claims 5 to 7.
